# FASCICULE DE BREVET EUROPEEN

(11) **EP 3 176 095 B1**
(45) Date de publication et mention de la délivrance du brevet: **30.01.2019**
(21) Numéro de dépôt: 16201613.3
(22) Date de dépôt: 01.12.2016
(51) Int. Cl.: B64G 1/22, B64G 1/44

(54) **STRUCTURE DEPLOYABLE COMPORTANT UN ENSEMBLE DE GENERATEURS SOLAIRES, SYSTEME DE DEPLOIEMENT D'UNE TELLE STRUCTURE DEPLOYABLE ET SATELLITE COMPORTANT UN TEL SYSTEME**
AUSKLAPPBARE STRUKTUR, DIE EINE GESAMTHEIT VON SOLARGENERATOREN UMFASST, AUSKLAPPSYSTEM EINER SOLCHEN AUSKLAPPBAREN STRUKTUR UND SATELLIT, DER EIN SOLCHES SYSTEM UMFASST
DEPLOYABLE STRUCTURE COMPRISING A SET OF SOLAR GENERATORS, SYSTEM FOR DEPLOYING SUCH A DEPLOYABLE STRUCTURE AND SATELLITE COMPRISING SUCH A SYSTEM

(30) Priorité: 02.12.2015 FR 1502511
(43) Date de publication de la demande: 07.06.2017
(73) Titulaire: Thales, 92400 Courbevoie (FR)
(72) Inventeur: BAUDASSE, Yannick, 06156 CANNES-LA-BOCCA Cedex (FR); VEZAIN, Stéphane, 06210 MANDELIEU (FR); BARDEL, Olivier, 06156 CANNES-LA-BOCCA Cedex (FR); STANEK, Didier, 06150 CANNES LA BOCCA (FR)
(74) Mandataire: Esselin, Sophie

(56) Documents cités:
- EP-A2- 2 108 901
- FR-A1- 2 508 413
- FR-A1- 2 998 876
- US-A1- 2011 210 209
- US-B1- 8 616 502
- US-B1- 8 683 755

## Description

La présente invention concerne une structure déployable comportant un ensemble de générateurs solaires, un système de déploiement d'une telle structure déployable et un satellite comportant un tel système. Elle s'applique au domaine des équipements spatiaux qui doivent être déployés en orbite et plus particulièrement aux générateurs solaires implantés sur un satellite.

Les structures déployables dans l'espace, de type générateur solaire par exemple, sont généralement constituées de panneaux rigides articulés entre eux, ces panneaux étant, en position stockée, empilés les uns au-dessus des autres. Ces structures ont l'avantage d'avoir une cinématique maîtrisée mais présentent le désavantage d'une masse surfacique et d'une inertie importantes. En outre, les structures rigides occupent, en position stockée, un encombrement important sous la coiffe d'un lanceur. L'espace alloué, aux structures déployables, sous la coiffe d'un lanceur, étant limité, il est important de réduire l'encombrement de ces structures déployables lorsqu'elles sont en position stockée de façon à en optimiser la surface en position déployée.

Afin de contrer ces inconvénients, il est connu, notamment du document FR 2 998 876, de réaliser des générateurs solaires flexibles qui présentent de nombreux avantages de compétitivité par rapport aux panneaux rigides. En particulier, ils présentent une capacité d'aménagement supérieure et une augmentation de la surface utile en position déployée.

Le document US 8 894 017 décrit un ensemble de générateurs solaires déployables articulés au bout d'un mât fixé sur une face d'un satellite. Différents segments supportant les générateurs solaires flexibles sont montés bout à bout et articulés entre eux. Cependant, en position stockée, les segments supportant les générateurs solaires flexibles ne sont pas opérationnels ce qui nécessite d'ajouter un panneau solaire rigide, monté sur le mât, qui, en position stockée, comporte des cellules solaires actives orientées vers l'extérieur du satellite pour pouvoir alimenter le satellite. Par ailleurs, il est nécessaire d'ajouter des moyens d'orientation du panneau solaire rigide pour pouvoir l'utiliser également en position déployée. En outre, le déploiement du mât et des générateurs solaires est réalisé séquentiellement, ce qui nécessite plusieurs commandes différentes pour déployer complètement l'ensemble de la structure déployable.

Le but de l'invention est de réaliser une structure déployable comportant un ensemble de générateurs solaires et un système de déploiement de cette structure déployable ne comportant pas les inconvénients des structures déployables et des systèmes de déploiement existants, présentant l'avantage d'être peu encombrants, simples à réaliser, présentant une simplification des séquences de déploiement et des commandes associées, permettant de disposer d'une zone de cellules solaires opérationnelle en position stockée et permettant un déploiement simultanée du mât et des générateurs solaires flexibles.

Pour cela, l'invention concerne une structure déployable comportant un ensemble de générateurs solaires, la structure déployable comportant un mât d'éloignement et deux rouleaux de stockage supportant chacun un générateur solaire flexible, les deux rouleaux de stockage étant articulés sur le mât, le mât ayant une première extrémité appelée base, une deuxième extrémité opposée à la base et comportant au moins une tige longitudinale située entre la première et la deuxième extrémité. Le mât comporte en outre deux bras latéraux montés à la deuxième extrémité, les deux bras latéraux étant inclinés angulairement selon deux directions opposées et symétriques par rapport à la tige longitudinale, chaque bras latéral comportant une extrémité munie d'un guide creux. Chaque rouleau de stockage a un axe longitudinal comportant une extrémité coudée formant un pivot respectivement articulé à l'intérieur du guide creux d'un bras latéral correspondant, le pivot de chaque rouleau de stockage ayant un axe de révolution différent de l'axe longitudinal du rouleau de stockage correspondant.

Avantageusement, les deux bras latéraux du mât peuvent être solidarisés à la tige longitudinale.

Alternativement, la tige peut comporter deux parties longitudinales distinctes, appelées respectivement première tige et deuxième tige, la deuxième tige étant parallèle à la première tige et articulée sur un axe de rotation situé à la deuxième extrémité du mât, l'axe de rotation étant perpendiculaire à la première et à la deuxième tige, les deux bras latéraux étant solidarisés à la deuxième tige.

Avantageusement, chaque générateur solaire flexible peut comporter une extrémité terminale rigidement attachée à un ancrage rigide fixe respectif, et la structure déployable peut comporter en outre au moins un volet rigide fixé à l'ancrage rigide, dans le prolongement d'un générateur solaire flexible, le volet rigide comportant des cellules solaires orientées en permanence vers le Soleil.

Alternativement, en position stockée, chaque générateur solaire flexible peut être partiellement enroulé autour du rouleau de stockage, et comporter une partie d'extrémité munie de cellules solaires orientées en permanence vers le Soleil.

Avantageusement, les guides creux de chaque bras latéral du mât peuvent être orientés à 45° par rapport au mât et par rapport aux axes longitudinaux respectifs des rouleaux de stockage

L'invention concerne également un système de déploiement comportant une structure déployable et comportant en outre un unique moteur comportant un rotor monté sur la base du mât, le rotor ayant un axe de rotation perpendiculaire à la tige longitudinale du mât, une première poulie située à la base du mât et ayant un axe de révolution aligné avec l'axe de rotation du rotor, deux poulies d'entraînement des rouleaux de stockage, en rotation, respectivement fixées aux extrémités coudées de chaque rouleau de stockage, des poulies de renvoi fixées sur les bras latéraux du mât et un ensemble de câbles reliant la première poulie aux poulies d'entrainement de chaque rouleau de stockage par l'intermédiaire des poulies de renvoi, les poulies d'entrainement ayant un axe de rotation respectif coïncidant avec un axe longitudinal des guides creux respectifs.

Avantageusement, chaque poulie d'entrainement d'un rouleau de stockage peut avoir un axe de rotation faisant un angle de 45° par rapport à l'axe longitudinal du rouleau de stockage correspondant et par rapport à la tige longitudinale du mât.

L'invention concerne enfin un satellite comportant un tel système de déploiement.

D'autres particularités et avantages de l'invention apparaîtront clairement dans la suite de la description donnée à titre d'exemple purement illustratif et non limitatif, en référence aux dessins schématiques annexés qui représentent :
- figure 1 : un schéma de face, en position stockée, d'un exemple de structure déployable comportant deux rouleaux de stockage sur lesquels sont enroulés des générateurs solaires flexibles respectifs, et d'un système de déploiement associé, selon l'invention;
- figure 2 : un schéma, en perspective, en position stockée, d'un exemple de structure déployable comportant un seul rouleau de stockage sur lequel est enroulé un générateur solaire flexible et d'un système de déploiement associé, selon l'invention;
- figure 3a : un schéma en perspective, illustrant la structure déployable de la figure 2, après déverrouillage, selon l'invention ;
- figures 3b, 3c, 3d : des schémas en perspective, illustrant les structures déployables des figures 1 et 2, respectivement en début, en cours et en fin de déploiement, selon l'invention ;
- figure 4a : un schéma en coupe transversale, en position stockée, d'une structure déployable comportant deux rouleaux de stockage munis de générateurs solaires flexibles respectifs, dans laquelle chaque générateur solaire comporte en outre un volet rigide dans le prolongement du support flexible, selon un mode de réalisation de l'invention ;
- figure 4b : un schéma en coupe transversale, montrant le sens de déploiement de la structure déployable conforme à la figure 4a, selon l'invention ;
- figure 5a : deux schémas, en perspective, en position stockée, d'une variante de réalisation de la structure déployable comportant deux rouleaux de stockage munis de générateurs solaires flexibles respectifs, dans laquelle, en position stockée, les générateurs solaires flexibles sont partiellement enroulés, selon l'invention;
- figure 5b : un schéma en coupe transversale, en position stockée, de la structure déployable conforme à la figure 5a, selon l'invention ;
- figure 5c : un schéma en coupe transversale, montrant le sens de déploiement de la structure déployable conforme à la figure 5a, selon l'invention ;
- figures 6a, 6b, 6c : trois séquences successives, en perspective, du déploiement de la structure déployable de la figure 5a, selon l'invention ;
- figure 7 : un schéma en coupe d'un exemple de satellite comportant des générateurs solaires flexibles en position stockée, sous la coiffe d'une fusée, selon l'invention.

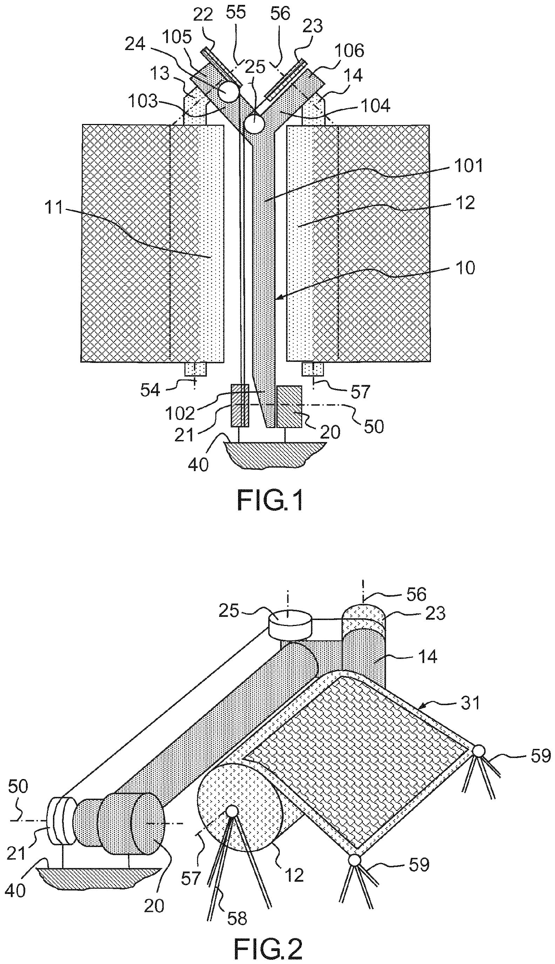

La structure déployable, représentée en position stockée sur la figure 1, comporte un mât 10 d'éloignement et deux rouleaux de stockage 11, 12, sur lesquels sont enroulés des générateurs solaires flexibles. les deux rouleaux de stockage, par exemple des cylindriques, supportent chacun un générateur solaire flexible et comportent chacun un pivot 13, 14 respectif articulé sur le mât. En position stockée, les deux rouleaux de stockage 11, 12 sont parallèles au mât 10 et les générateurs solaires flexibles sont enroulés autour des deux rouleaux de stockage. Le mât comporte une tige 101 longitudinale située entre une première extrémité 102 du mât appelée base et une deuxième extrémité opposée à la base, et deux bras latéraux 103, 104 situés à la deuxième extrémité du mât. Les deux bras latéraux 103, 104 sont inclinés angulairement selon deux directions opposées et symétriques par rapport à la tige 101 longitudinale. Les deux bras latéraux 103, 104 peuvent être solidarisés à la tige 101. Les deux bras latéraux peuvent également être constitués d'une ferrure monobloc, métallique ou composite.

Chaque bras latéral 103, 104 comporte une extrémité munie d'un guide creux 105, 106 cylindrique dont l'axe longitudinal 55, 56 est incliné angulairement par rapport à la tige longitudinale 101 du mât 10. Chaque rouleau de stockage 11, 12 a un axe longitudinal comportant une extrémité coudée formant le pivot 13, 14 articulé à l'intérieur du guide creux 105, 106 correspondant. Le pivot 13, 14 de chaque rouleau de stockage a un axe de révolution 55, 56 différent de l'axe longitudinal 54, 57 du rouleau de stockage 11, 12 correspondant. L'articulation entre le pivot 13, 14 de chaque rouleau de stockage 11, 12 et le guide creux 105, 106 correspondant, permet une rotation du pivot autour de son axe de révolution.

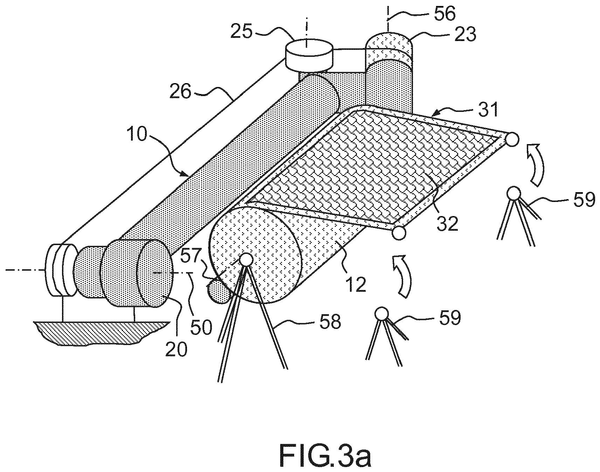

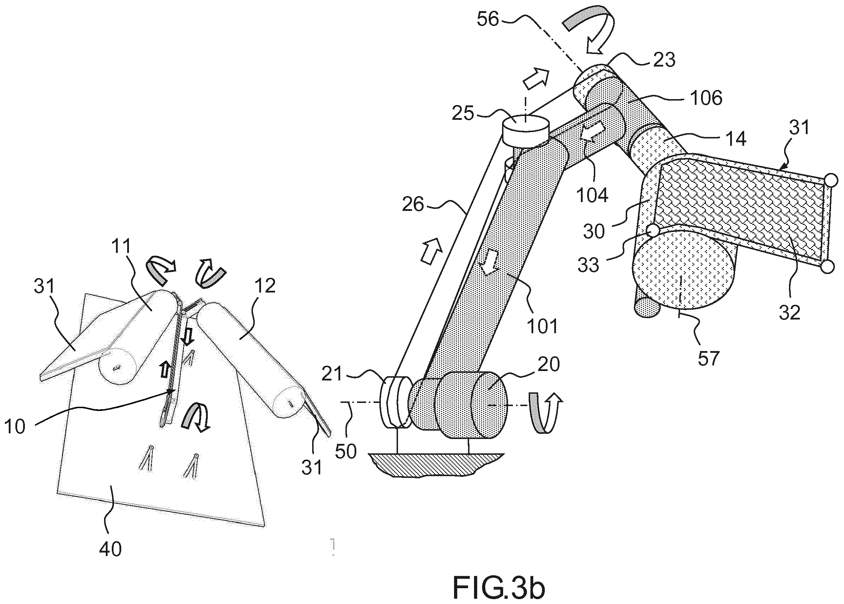

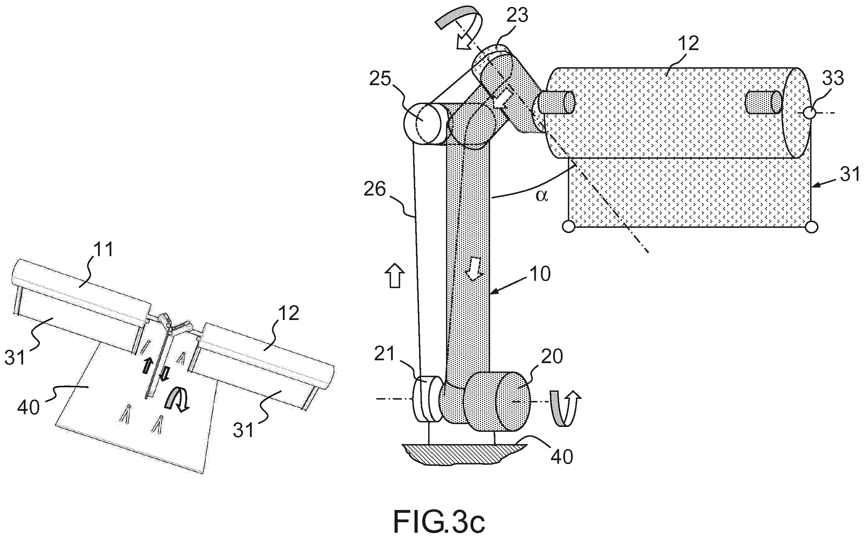

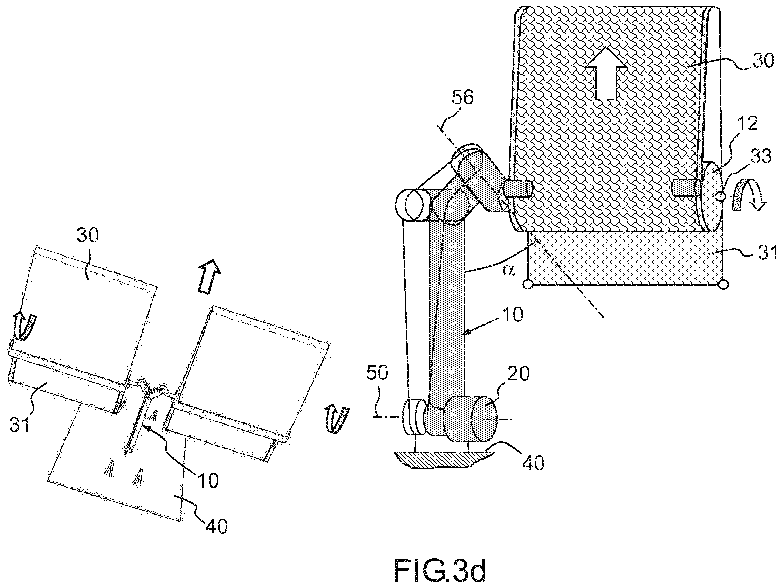

Comme illustré en particulier sur les figures 3c et 3d, les guides creux 105, 106 respectifs de chaque bras latéral 103, 104 du mât et les axes de révolution des pivots 13, 14 de chaque rouleau de stockage peuvent être, de préférence, orientés dans une direction faisant un angle α de 45° par rapport à la tige longitudinale du mât et par rapport aux axes longitudinaux respectifs des rouleaux de stockage de façon à minimiser le nombre de séquences nécessaires pour le déploiement de la structure et le bon positionnement des rouleaux de stockage en position déployée. En particulier, cela permet, en position déployée, d'obtenir un positionnement de l'axe longitudinal des rouleaux de stockage perpendiculaire à la tige du mât, comme illustré sur la figure 3c, et donc de permettre un déploiement des générateurs solaires selon une direction parallèle à la tige du mât comme représenté sur la figure 3d. Bien entendu, il est également possible de choisir une orientation des guides creux dans une direction faisant un angle de valeur différente de 45° par rapport à la tige 101 longitudinale du mât 10 et par rapport aux axes longitudinaux respectifs des rouleaux de stockage 11, 12. Sur les figures 2 et 3a un seul rouleau de stockage est représenté afin de simplifier ces figures, mais bien entendu, cette cinématique de déploiement est valable pour deux rouleaux positionnés symétriquement par rapport au mat central 10, comme illustré sur chacune des figures 3b, 3c, 3d sur lesquelles deux exemples de cinématique de déploiement de structures déployables comportant respectivement un rouleau de stockage et deux rouleaux de stockage, sont représentés.

Le système de déploiement de la structure déployable comporte un unique moteur 20, du type moteur régulateur, ayant un stator destiné à être fixé sur une face 40 de la caisse 41 d'un satellite et un rotor monté directement sur la base 102 du mât, le rotor ayant un axe de rotation 50 perpendiculaire à la tige 101 du mât. Le rotor du moteur 20 est destiné à entrainer le mât 10 en rotation autour de l'axe de rotation 50 afin de le déployer. Le système de déploiement comporte également une première poulie 21, située à la base du mât et destinée à être fixée sur la face 40 de la caisse 41 du satellite, deux poulies d'entraînement 22, 23 des rouleaux de stockage en rotation, respectivement fixées aux extrémités coudées de chaque rouleau de stockage, des poulies de renvoi 24, 25 fixées sur les bras latéraux du mât et un ensemble de câbles 26 reliant la première poulie 21 aux poulies d'entrainement 22, 23 du rouleau de stockage par l'intermédiaire des poulies de renvoi 24, 25. La première poulie 21 a un axe de révolution aligné avec l'axe de rotation 50 du rotor du moteur 20. Les poulies d'entrainement 22, 23 ont un axe de révolution coïncidant avec l'axe des guides creux 105, 106 respectifs et ont pour fonction de déployer les rouleaux de stockage pendant le déploiement du mât, le déploiement du mât 10 et des rouleaux de stockage 11, 12 étant ainsi réalisé simultanément. Les poulies de renvoi 24, 25 sont fixées sur le mât, par exemple à l'embranchement entre la tige longitudinale et chaque bras latéral, leur axe de rotation étant orienté selon une direction perpendiculaire au mât. La première poulie 21 est engrenée via des câbles sur les poulies de renvoi 24, 25, puis sur les poulies d'entrainement 22, 23. Les poulies d'entraînement sont directement fixées sur les extrémités coudées des rouleaux de stockage et leurs axes de rotation sont respectivement orientés dans la même direction que les axes longitudinaux des guides creux et sont donc inclinés angulairement par rapport à la tige longitudinale du mât. Par exemple, lorsque les axes longitudinaux des guides creux respectifs de chaque bras latéral du mât font un angle de 45° par rapport à la tige longitudinale du mât et par rapport aux axes de révolution respectifs des rouleaux de stockage, l'axe de rotation de chaque poulie d'entrainement fait également un angle égal à 45°, par rapport à l'axe de révolution du rouleau de stockage correspondant et par rapport à la tige longitudinale du mât.

Bien qu'une seule poulie de renvoi soit visible sur les différentes figures, pour chaque rouleau de stockage à déployer, deux poulies de renvoi, diamétralement opposées sur le mât, sont nécessaires pour avoir un chemin de câble fermé, partant de la poulie fixe jusqu'à la poulie d'entrainement par l'intermédiaire d'une première poulie de renvoi, puis revenant de la poulie d'entraînement jusqu'à la poulie fixe par l'intermédiaire de la deuxième poulie de renvoi. Sur les figures 3b, 3c, 3d, le chemin de câble est représenté en trait plein sur la face visible de la structure déployable, et en traits pointillés sur la face opposée qui est cachée. Pour chaque rouleau de stockage, il est possible d'utiliser un seul câble ou deux câbles différents, aller et retour, pour réaliser le chemin complet. Deux chemins de câbles différents sont nécessaires pour déployer les deux rouleaux de stockage 11, 12, la première poulie 21 étant commune aux deux chemins de câbles respectivement dédiés aux deux rouleaux de stockage.

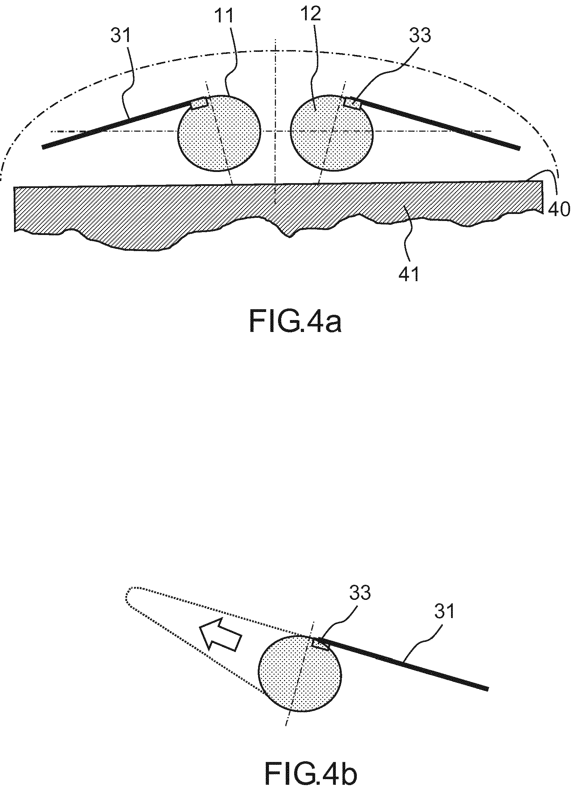

Chaque rouleau de stockage 11, 12, supporte un générateur solaire flexible 30 qui, en position stockée, est enroulé autour du rouleau de stockage respectif. Chaque générateur solaire flexible comporte classiquement, un support flexible sur lequel sont montées des cellules solaires. Le support flexible de chaque générateur solaire flexible comporte une première extrémité apte à être enroulée autour dudit rouleau de stockage et une deuxième extrémité terminale rigidement attachée à un ancrage rigide 33 fixe. Avantageusement, selon un premier mode de réalisation correspondant aux figures 3b, 3c, 3d, et aux figures 4a et 4b, l'ancrage rigide 33 peut être disposé de façon diamétralement opposée par rapport à la face 40 de la caisse 41 du satellite et la structure déployable peut comporter en outre, un volet rigide 31 fixé à l'ancrage rigide 33, dans le prolongement du générateur solaire flexible 30, le volet rigide étant équipé de cellules solaires. Dans ce cas, en position stockée, le substrat flexible est complètement enroulé autour du rouleau de stockage alors que le volet rigide reste déployé en permanence. Comme représenté sur la figure 4a, le volet rigide 31 comporte une face arrière orientée vers la face 40 de la caisse 41 du satellite et une face avant orientée en permanence vers l'extérieur du satellite, la face avant du volet rigide 31 étant équipée de cellules solaires 32, orientées en permanence vers le Soleil, pendant toutes les phases stockées et déployées de la structure déployable. La figure 4b illustre, en traits pointillés, le sens de déploiement d'un générateur solaire flexible 30 lorsque la structure déployable comporte en outre un volet rigide 31 fixé dans le prolongement d'un générateur solaire flexible correspondant.

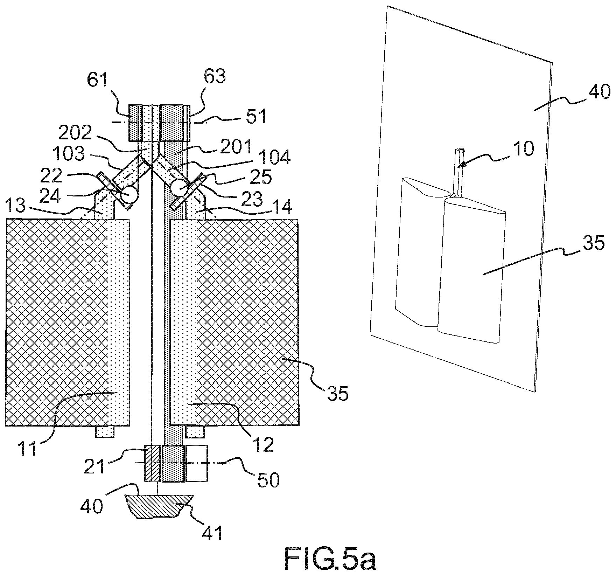

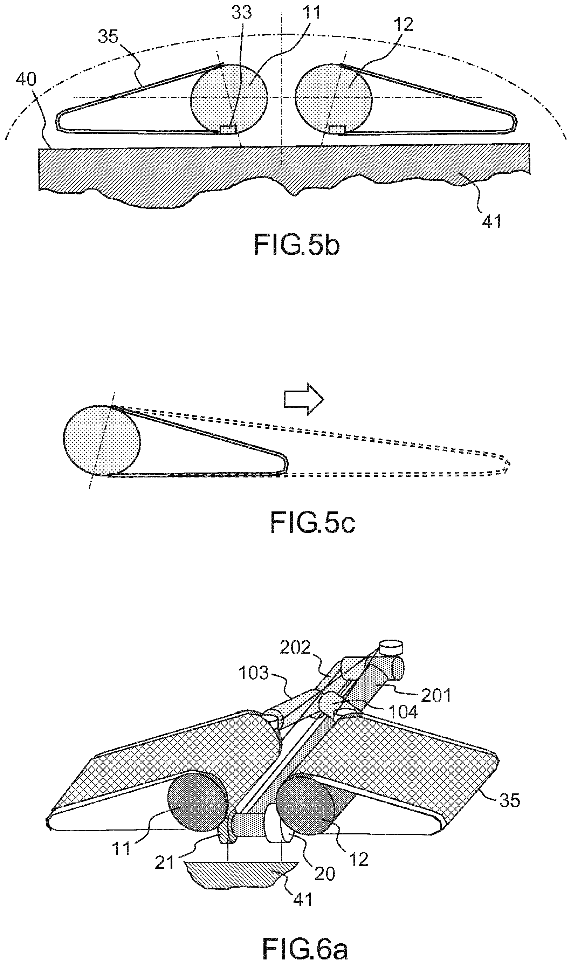

Selon une variante de réalisation de l'invention, comme le montre la figure 5a, la tige longitudinale du mât 10 peut comporter deux parties distinctes 201, 202. Les deux parties distinctes sont constituées d'une première tige 201 longitudinale fixée entre les deux extrémités du mât et d'une deuxième tige 202 longitudinale articulée sur un axe de rotation 51 situé à la deuxième extrémité du mât. La deuxième tige est parallèle à la première tige et l'axe de rotation 51 est perpendiculaire à la première et à la deuxième tige du mât. Les deux bras latéraux 103, 104, inclinés angulairement et disposés symétriquement par rapport au mât, sont solidarisés à la deuxième tige 202. Dans cette variante de réalisation de l'invention, le générateur solaire ne comporte pas de volet rigide mais, pour que l'ensemble de générateurs solaires puisse fournir de l'énergie pendant toutes les phases stockées et déployées de la structure déployable, l'ancrage rigide 33 peut être positionné face à la face 40 de la caisse 41 du satellite comme représenté sur la figure 5b et chaque générateur solaire flexible 30 peut, en position stockée, être partiellement enroulé autour du rouleau de stockage 11, 12 et présenter une partie d'extrémité 35 partiellement déroulée et munie de cellules solaires orientées en permanence vers le Soleil.

La figure 5c illustre, en traits pointillés, le sens de déploiement d'un générateur solaire flexible selon cette variante de réalisation de l'invention, dans lequel le générateur solaire ne comporte pas de volet rigide. La partie d'extrémité 35 partiellement déroulée, ou respectivement, le volet rigide 31, permet de fournir l'énergie nécessaire au satellite pendant la phase balistique où le satellite est mis en orbite, et contribue également, conjointement aux générateurs solaires flexibles, à l'alimentation du satellite en énergie électrique pendant la phase orbitale du satellite.

Ce système de déploiement permet un déploiement simultané du mât 10 et des deux rouleaux 11, 12 en utilisant un seul moteur 20 monté à la base 102 du mât. Différentes séquences de déploiement successives, concernant le cas simplifié où un seul rouleau est monté sur un mât qui ne comporte qu'une seule tige longitudinale 101, sont illustrées sur les figures 3a, 3b, 3c, 3d. Lorsque deux rouleaux de stockage sont montés sur le mât, les deux rouleaux sont déployés simultanément et symétriquement par rapport au mât. En position stockée, comme représenté sur la figure 2, les rouleaux de stockage 11, 12 sur lesquels sont enroulés des générateurs solaires, sont disposés avec leur axe longitudinal respectif parallèle à la tige du mât et sont verrouillés, dans la position stockée, sur des pieds de gerbage 58 fixés sur une face de satellite. Les panneaux solaires 31 rigides munis des cellules solaires 32 orientées vers l'extérieur, sont également verrouillés sur des pieds de gerbage 59 dédiés, fixés sur la face 40 du satellite.

Le déclenchement du déploiement de la structure déployable commence par le déverrouillage des panneaux solaires 31 rigides, puis des rouleaux 11, 12 comme représenté sur la figure 3b, puis par l'actionnement du rotor du moteur 20 situé à la base du mât. Lorsque le rotor du moteur 20 est actionné en rotation autour de son axe de rotation 50, il entraine le mât 10 en rotation, ce qui provoque un enroulement du câble 26 autour de la première poulie 21. L'enroulement du câble provoque une tension au niveau d'une poulie de renvoi 25 qui se met en rotation et transmet cette tension à la poulie d'entrainement 23 qui se met également en rotation. L'axe de rotation de la poulie d'entraînement étant solidaire de l'extrémité coudée formant le pivot 13, 14 des rouleaux de stockage 11, 12, la rotation de la poulie d'entraînement déclenche alors la rotation des rouleaux de stockage qui se déploient. L'entraînement du mât par le rotor du moteur 20 provoque donc, par l'intermédiaire des poulies, le déploiement simultané des rouleaux 11, 12. Pour passer de la position stockée à la position déployée, le mât 10 subit une rotation de 90° autour de l'axe de rotation 50 du rotor du moteur 20. Pendant cette rotation du mât, pour être correctement orienté, chaque rouleau de stockage 11, 12 doit subir une rotation de 180° autour de l'axe 55, 56 du pivot 13, 14 orienté à 45° et la poulie d'entraînement doit donc tourner de 180°. Pour cela, chaque poulie d'entrainement 22, 23 doit avoir un diamètre d'enroulement deux fois moins grand que le diamètre d'enroulement de la première poulie 21 située à la base du mât. Lorsque le mât et les rouleaux sont en position déployée, le mât et les rouleaux sont verrouillés dans cette position et le déploiement des générateurs flexibles est réalisé. Le déploiement de chaque générateur solaire peut être réalisé de manière connue, de façon autonome, par exemple au moyen d'un ou de plusieurs mètres-rubans fixés sur une toile flexible supportant les générateurs solaires flexibles.

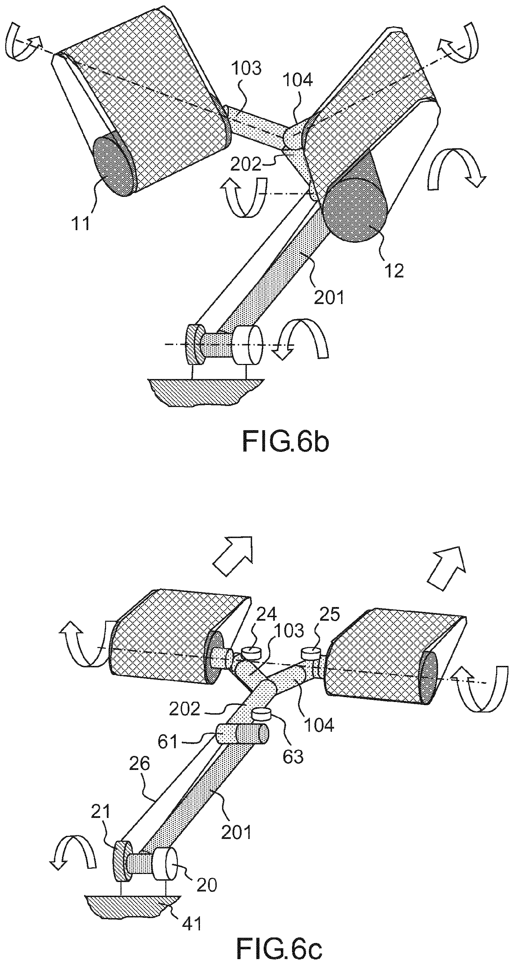

Les figures 6a, 6b, 6c illustrent différentes séquences de déploiement dans la variante de réalisation où deux rouleaux de stockage 11, 12 sont montés sur le mât 10 et où le mât comporte deux tiges longitudinales 201, 202. Dans la position stockée, la deuxième tige 202 du mât, équipée des deux bras latéraux 103, 104 sur lesquels sont articulés les deux rouleaux de stockage, est repliée contre la première tige 201, les bras latéraux étant orientés vers la base 102 du mât. Afin d'assurer le déploiement des deux tiges 201, 202 du mât et des rouleaux de stockage 11, 12, des câbles aller et retour sont fixés sur la première poulie 21 située à la base du mât, qui est fixe par rapport à la caisse du satellite, et sur une deuxième poulie 61 montée sur la deuxième tige longitudinale. Par ailleurs, des câbles aller et retour sont fixés sur les poulies d'entrainement 22, 23 des rouleaux et sur des poulies de renvoi 24, 25, 63 montées sur les bras latéraux et sur la première tige du mât. Le principe de déploiement est similaire à celui décrit en liaison avec les figures 3a, 3b, 3c, 3d. L'actionnement du moteur 20 situé à la base 102 du mât entraîne en rotation la première tige du mât, ce qui provoque le déploiement synchronisé de l'ensemble de la structure déployable, y compris la deuxième tige longitudinale du mât, par l'intermédiaire du système de câbles et de poulies.

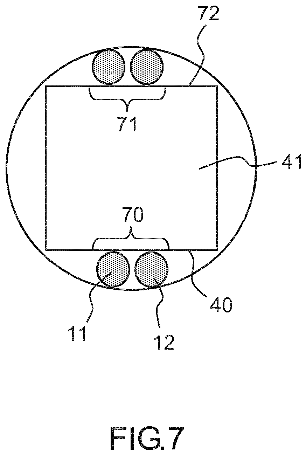

Comme représenté sur la figure 7, un satellite équipé d'au moins une structure déployable conforme à l'invention, comportant deux générateurs solaires enroulés autour de deux rouleaux 11, 12 respectifs, peut être aménagé dans une coiffe 5 de fusée étroite. Il est également possible, pour équilibrer la caisse 41 du satellite, d'aménager deux structures déployables, 70, 71 conformes à l'invention, sur deux faces opposées 40, 72 de la caisse du satellite. Les structures déployables sont, bien entendu, respectivement associées à un système de déploiement dédié.

Bien que l'invention ait été décrite en liaison avec des modes de réalisation particuliers, il est bien évident qu'elle n'y est nullement limitée et qu'elle comprend tous les équivalents techniques des moyens décrits ainsi que leurs combinaisons si celles-ci entrent dans le cadre de l'invention. En particulier, le nombre et l'emplacement des différentes poulies de renvoi n'est pas limité aux exemples spécifiquement décrits.

## Revendications

1. Structure déployable comportant un ensemble de générateurs solaires, la structure déployable comportant un mât (10) d'éloignement et deux rouleaux de stockage (11, 12) supportant chacun un générateur solaire flexible (30), les deux rouleaux de stockage (11, 12) étant articulés sur le mât (10), le mât (10) ayant une première extrémité (102) appelée base, une deuxième extrémité opposée à la base et comportant au moins une tige (101) longitudinale située entre la première et la deuxième extrémité, **caractérisée en ce que** le mât (10) comporte en outre deux bras latéraux (103, 104) montés à la deuxième extrémité, les deux bras latéraux étant inclinés angulairement selon deux directions opposées et symétriques par rapport à la tige (101) longitudinale, chaque bras latéral (103, 104) comportant une extrémité munie d'un guide creux (105, 106), et **en ce que** chaque rouleau de stockage (11,12) a un axe longitudinal (54, 57) comportant une extrémité coudée formant un pivot (13, 14) respectivement articulé à l'intérieur du guide creux (105, 106) d'un bras latéral correspondant, le pivot (13, 14) de chaque rouleau de stockage ayant un axe de révolution (55, 56) différent de l'axe longitudinal (54) du rouleau de stockage (11, 12) correspondant.

2. Structure déployable selon la revendication 1, **caractérisée en ce que** les deux bras latéraux (103, 104) du mât (10) sont solidarisés à la tige (101) longitudinale.

3. Structure déployable selon la revendication 1, **caractérisée en ce que** la tige (101) comporte deux parties longitudinales distinctes, appelées respectivement première tige et deuxième tige, la deuxième tige (202) étant parallèle à la première tige (201) et articulée sur un axe de rotation (51) situé à la deuxième extrémité du mât, l'axe de rotation (51) étant perpendiculaire à la première et à la deuxième tige (201, 202), les deux bras latéraux (103, 104) étant solidarisés à la deuxième tige (202).

4. Structure déployable selon la revendication 2, **caractérisée en ce que** chaque générateur solaire flexible (30) comporte une extrémité terminale rigidement attachée à un ancrage rigide (33) fixe respectif, et **en ce qu'**elle comporte en outre au moins un volet rigide (31) fixé à l'ancrage rigide (33), dans le prolongement d'un générateur solaire flexible (30), le volet rigide (31) comportant des cellules solaires orientées en permanence vers le Soleil.

5. Structure déployable selon la revendication 3, **caractérisée en ce que**, en position stockée, chaque générateur solaire flexible (30) est partiellement enroulé autour du rouleau de stockage (11, 12), et comporte une partie d'extrémité (35) munie de cellules solaires orientées en permanence vers le Soleil.

6. Structure déployable selon l'une des revendications 4 ou 5, **caractérisée en ce que** les guides creux de chaque bras latéral (103, 104) du mât (10) sont orientés à 45° par rapport au mât (10) et par rapport aux axes longitudinaux (54) respectifs des rouleaux de stockage (11, 12).

7. Système de déploiement comportant une structure déployable selon l'une des revendications 1 à 6, **caractérisé en ce qu'**il comporte en outre un unique moteur (20) comportant un rotor monté sur la base (102) du mât (10), le rotor ayant un axe de rotation (50) perpendiculaire à la tige (101) longitudinale du mât, une première poulie (21) située à la base du mât et ayant un axe de révolution aligné avec l'axe de rotation (50) du rotor, deux poulies d'entraînement (22, 23) des rouleaux de stockage (11, 12), en rotation, respectivement fixées aux extrémités coudées de chaque rouleau de stockage, des poulies de renvoi (24, 25) fixées sur les bras latéraux du mât et un ensemble de câbles (26) reliant la première poulie (21) aux poulies d'entrainement (22, 23) de chaque rouleau de stockage par l'intermédiaire des poulies de renvoi (24, 25), les poulies d'entrainement ayant un axe de rotation respectif coïncidant avec un axe longitudinal des guides creux (105, 106) respectifs.

8. Système de déploiement selon la revendication 7, **caractérisé en ce que** chaque poulie d'entrainement (22, 23) d'un rouleau de stockage (11, 12) a un axe de rotation faisant un angle de 45° par rapport à l'axe longitudinal du rouleau de stockage correspondant et par rapport à la tige (101) longitudinale du mât (10).

9. Satellite, **caractérisé en ce qu'**il comporte au moins un système de déploiement selon l'une des revendications 7 ou 8.

## Patentansprüche

1. Ausklappbare Struktur, welche eine Gruppe von Solargeneratoren beinhaltet, wobei die ausklappbare Struktur einen Abstandsmast (10) und zwei Lagerungsrollen (11, 12) beinhaltet, welche jeweils einen flexiblen Solargenerator (30) stützen, wobei die beiden Lagerungsrollen (11, 12) gelenkig mit dem Mast (10) verbunden sind, wobei der Mast (10) ein erstes Ende (102) besitzt, genannt Basis, ein zweites, der Basis gegenüber liegendes Ende, welches mindestens einen Längsstab (101) beinhaltet, welcher zwischen dem ersten und dem zweiten Ende befindlich ist, **dadurch gekennzeichnet, dass** der Mast (10) zudem zwei seitliche Arme (103, 104) beinhaltet, welche am zweiten Ende montiert sind, wobei die beiden seitlichen Arme winklig entlang zwei entgegengesetzten Richtungen geneigt sind und in Bezug auf den Längsstab (101) symmetrisch sind, wobei jeder seitliche Arm (103, 104) ein Ende besitzt, welches mit einem hohlen Führungselement (105, 106) versehen ist und dadurch, dass jede Lagerungsrolle (11, 12) eine Längsachse (54, 57) besitzt, welche ein gekröpftes Ende beinhaltet, welches eine Schwenkachse (13, 14) bildet, welche jeweils im Innern des hohlen Führungselementes (105, 106) eines entsprechenden seitlichen Arms gelenkig verbunden ist, wobei die Schwenkachse (13, 14) einer jeden Lagerungsrolle eine Umdrehungsachse (55, 56) besitzt, die sich von der Längsachse (54) der entsprechenden Lagerungsrolle (11, 12) unterscheidet.

2. Ausklappbare Struktur nach Anspruch 1, **dadurch gekennzeichnet, dass** die beiden seitlichen Arme (103, 104) des Mastes (10) fest mit dem Längsstab (101) verbunden sind.

3. Ausklappbare Struktur nach Anspruch 1, **dadurch gekennzeichnet, dass** der Stab (101) zwei unterschiedliche Längsteile besitzt, jeweils genannt erster Stab und zweiter Stab, wobei der zweite Stab (202) parallel zum ersten Stab (201) ist und gelenkig mit einer Drehachse (51) verbunden ist, welche am zweiten Ende des Mastes befindlich ist, wobei die Drehachse (51) rechtwinklig zum ersten und zum zweiten Stab (201, 202) ist, wobei die beiden seitlichen Arme (103, 104) fest mit dem zweiten Stab (202) verbunden sind.

4. Ausklappbare Struktur nach Anspruch 2, **dadurch gekennzeichnet, dass** jeder flexible Solargenerator (30) einen Endabschnitt beinhaltet, welcher starr mit einer jeweiligen festen, starren Verankerung (33) verbunden ist, und dadurch, dass sie zudem mindestens eine starre Klappe (31) in der Verlängerung eines flexiblen Solargenerators (30) beinhaltet, welche an der starren Verankerung (33) befestigt ist, wobei die starre Klappe (31) permanent in Richtung der Sonne ausgerichtete Solarzellen beinhaltet.

5. Ausklappbare Struktur nach Anspruch 3, **dadurch gekennzeichnet, dass** in gelagerter Position jeder flexible Solargenerator (30) teilweise um die Lagerungsrolle (11, 12) aufgerollt ist, und einen Endabschnitt (35) beinhaltet, welcher mit permanent in Richtung der Sonne ausgerichtete Solarzellen versehen ist.

6. Ausklappbare Struktur nach einem der Ansprüche 4 oder 5, **dadurch gekennzeichnet, dass** die hohlen Führungselemente eines jeden seitlichen Arms (103, 104) des Mastes (10) in 45° in Bezug auf den Mast (10) und in Bezug auf die jeweiligen Längsachsen (54) der Lagerungsrollen (11, 12) ausgerichtet sind.

7. Ausklappsystem, beinhaltend eine ausklappbare Struktur nach einem der Ansprüche 1 bis 6, **dadurch gekennzeichnet, dass** es zudem einen einzigen Motor (20) beinhaltet, welcher einen an der Basis (102) des Mastes (10) montierten Rotor beinhaltet, wobei der Rotor eine Drehachse (50) besitzt, welche rechtwinklig zum Längsstab (101) des Mastes ist, eine erste Scheibe (21), welche an der Basis des Mastes befindlich ist und eine Umlaufachse besitzt, welche mit der Drehachse (50) des Rotors fluchtet, zwei Antriebsscheiben (22, 23) der Lagerungsrollen (11, 12) in Rotation, welche jeweils an den gekröpften Enden einer jeden Lagerungsrolle befestigt sind, Umlenkscheiben (24, 25), welche an den seitlichen Armen des Mastes befestigt sind und eine Gruppe von Kabeln (26), welche die erste Scheibe (21) mit den Antriebsscheiben (22, 23) einer jeden Lagerungsrolle in Vermittlung der Umlenkscheiben (24, 25) verbinden, wobei die Antriebsscheiben eine jeweilige Drehachse besitzen, welche mit einer Längsachse der jeweiligen hohlen Führungselemente (105, 106) übereinstimmt.

8. Ausklappsystem nach Anspruch 7, **dadurch gekennzeichnet, dass** jede Antriebsscheibe (22, 23) einer Lagerungsrolle (11, 12) eine Drehachse besitzt, welche einen Winkel von 45° zur Längsachse der entsprechenden Lagerungsrolle und zum Längsstab (101) des Mastes (10) bildet.

9. Satellit, **dadurch gekennzeichnet, dass** er mindestens ein Ausklappsystem nach einem der Ansprüche 7 oder 8 beinhaltet.

## Claims

1. Deployable structure comprising a set of solar generators, the deployable structure comprising a separating mast (10) and two storage rollers (11, 12) each supporting a flexible solar generator (30), the two storage rollers (11, 12) being articulated on the mast (10), the mast (10) having a first end (102), called base, a second end opposite the base, and comprising at least one longitudinal rod (101) situated between the first and the second ends, **characterized in that** the mast (10) further comprises two lateral arms (103, 104) mounted at the second end, the two lateral arms being inclined angularly in two opposite directions that are symmetrical relative to the longitudinal rod (101), each lateral arm (103, 104) comprising an end provided with a hollow guide (105, 106), and **in that** each storage roller (11, 12) has a longitudinal axis (54, 57) comprising a bent end forming a pivot (13, 14) respectively articulated inside the hollow guide (105, 106) of a corresponding lateral arm, the pivot (13, 14) of each storage roller having an axis of revolution (55, 56) different from the longitudinal axis (54) of the corresponding storage roller (11, 12).

2. Deployable structure according to Claim 1, **characterized in that** the two lateral arms (103, 104) of the mast (10) are secured to the longitudinal rod (101).

3. Deployable structure according to Claim 1, **characterized in that** the rod (101) comprises two distinct longitudinal parts, respectively called first rod and second rod, the second rod (202) being parallel to the first rod (201) and articulated on an axis of rotation (51) situated at the second end of the mast, the axis of rotation (51) being at right angles to the first and the second rod (201, 202), the two lateral arms (103, 104) being secured to the second rod (202).

4. Deployable structure according to Claim 2, **characterized in that** each flexible solar generator (30) comprises a terminal end rigidly attached to a respective fixed rigid anchor point (33), and **in that** it further comprises at least one rigid flap (31) fixed to the rigid anchor point (33), in the extension of a flexible solar generator (30), the rigid flap (31) comprising solar cells permanently oriented towards the sun.

5. Deployable structure according to Claim 3, **characterized in that**, in stored position, each flexible solar generator (30) is partially wound around the storage roller (11, 12), and comprises an end part (35) provided with solar cells permanently oriented towards the sun.

6. Deployable structure according to one of Claims 4 or 5, **characterized in that** the hollow guides of each lateral arm (103, 104) of the mast (10) are oriented at 45° relative to the mast (10) and relative to the respective longitudinal axes (54) of the storage rollers (11, 12).

7. Deployment system comprising a deployable structure according to one of Claims 1 to 6, **characterized in that** it further comprises a single motor (20) comprising a rotor mounted on the base (102) of the mast (10), the rotor having an axis of rotation (50) at right angles to the longitudinal rod (101) of the mast, a first pulley (21) situated at the base of the mast and having an axis of revolution aligned with the axis of rotation (50) of the rotor, two pulleys (22, 23) driving the storage rollers (11, 12), in rotation, respectively fixed to the bent ends of each storage roller, return pulleys (24, 25) fixed to the lateral arms of the mast and a set of cables (26) linking the first pulley (21) to the pulleys (22, 23) driving each storage roller via the return pulleys (24, 25), the driving pulleys having a respective axis of rotation coinciding with a longitudinal axis of the respective hollow guides (105, 106).

8. Deployment system according to Claim 7, **characterized in that** each pulley (22, 23) driving a storage roller (11, 12) has an axis of rotation forming an angle of 45° relative to the longitudinal axis of the corresponding storage roller and relative to the longitudinal rod (101) of the mast (10).

9. Satellite, **characterized in that** it comprises at least one deployment system according to one of Claims 7 or 8.
